# EUROPÄISCHE PATENTANMELDUNG

(11) **EP 0 831 682 A1**
(43) Veröffentlichungstag der Anmeldung: **25.03.1998**
(21) Anmeldenummer: 97114008.2
(22) Anmeldetag: 13.08.1997
(51) Int. Cl.: H05K 1/11

(54) **Leiterplatte**

(30) Priorität: 19.09.1996 DE 29616339 U
(71) Anmelder: SIEMENS AKTIENGESELLSCHAFT, 80333 München (DE)
(72) Erfinder: Bandmann, Joachim, 58454 Witten (DE); Cohaupt, Ulrich, 58454 Witten (DE); Holtkamp, Klaus, 58239 Schwerte (DE); Redwitz, Klaus, 58455 Witten (DE)

(57) **Zusammenfassung**

Die Leiterplatte (1) weist an mindestens einem ihrer Randbereiche (4) Kontaktflächen (2) auf, die mit einzelnen Leiterbahnen (3) verbunden sind. Sie dienen dazu, mit einem Gegenkontakt zu kontaktieren. Jede Kontaktfläche (2) ist in mehrere miteinander verbundene Teilflächen (5) strukturiert. Vorzugsweise ist eine kammartige Strukturierung vorgesehen. Damit wird erreicht, daß bei dem für die bestückte Leiterplatte notwendigen Lötvorgang (z.B. Schwall-Löten) im Gegensatz zu einem vollflächigen Kontaktbereich die erfindungsgemäß strukturierten Kontaktteilflächen (2) eine gleichmäßig dünne Lotschicht annehmen. Dadurch wird eine sehr gute Kontaktierfähigkeit mit dem jeweiligen Gegenkontakt sichergestellt. Dies gilt sowohl für Leiterplatten mit bereits vorverzinnten Leiterbahnen, als auch für Leiterplatten, die mit einem Schutzlack überzogen sind.

## Beschreibung

Die Erfindung betrifft eine Leiterplatte, die an mindestens einem ihrer Randbereiche mit einer Leiterbahn verbundene Kontaktflächen aufweist. Diese dienen dazu, bei ihrem bestimmungsgemäßen Gebrauch mit jeweils einem Gegenkontakt einer Steckeranordnung zu kontaktieren. Eine Leiterplatte wird zunächst insoweit fertiggestellt, als sie entsprechend dem gewählten Leiterplatten-Layout die auf der Leiterplatte vorzusehenden Leiterbahnen und die Lötstellen in Form von Lötaugen bzw. in Form anderer mit dem Lot zu bedeckenden Flächen aufweist. Zur Bildung von Funktions- bzw. Baueinheiten werden diese Leiterplatten mit den entsprechenden Werkstücken bzw. Bauelementen bestückt. Dies erfolgt im Allgemeinen nur auf einer Seite der Leiterplatte, da die andere Seite unter anderem für das Löten der durch entsprechenden Durchtrittsöffnungen hindurchragende Anschlußstifte freigehalten wird. Eine derartige, elektrische Bauelemente tragende Leiterplatte wird z.B. als elektrische Baugruppe gegebenenfalls zusammen mit weiteren Baugruppen in eine konstruktiv entsprechend angepaßte Aufnahmeeinheit eingebracht bzw. sie wird auf eine Grundplatte aufgesteckt. Je nach Anwendungsfall werden die an mindestens einem Randbereich der Leiterplatte vorhandenen, in der Regel als Streifen von wenigen Millimetern Breite ausgebildeten eine oder mehrere Kontaktflächen unmittelbar mit einer Gegensteckeinrichtung in Eingriff gebracht. Bei der damit hergestellten elektrischen Verbindung zwischen zwei Einheiten muß eine sichere Kontaktierung erfolgen, um eine einwandfreie Funktion zu ermöglichen. Als handelsübliche Einheit können Leiterplatten bezogen werden, deren Kupferauflagen in Form von Leiterbahnen und in Form dieser Kontaktflächen entweder durch eine Vorverzinnung oder durch einen geeigneten Schutzlack gegen Korrosion geschützt sind. Durch den nach der Bestückung einer Leiterplatte mit den entsprechenden Bauelementen bzw. Werkstücken erfolgenden Lötvorgang - der beispielsweise in Form der sogenannten Schwall-Lötung oder auch in Form der sogenannten Reflow-Lötung erfolgen kann - wird das aufgebrachte Konservierungsmittel aufgebrochen und die betreffenden Stellen nehmen das Lot auf. Die genannten Kontaktflächen, die jeweils mit einem Gegenkontakt kontaktieren, werden in der Fachwelt allgemein als sogenannte Edge-Connectoren bezeichnet. Bei einem vorgenommenen Lötvorgang kommt es bei beiden genannten Leiterplattentypen ohne besondere Maßnahmen zu nicht reproduzierbaren Zinnanhäufungen. Diese führen dazu, daß eine sichere Kontaktierung nicht mehr vorausgesetzt werden kann. Es muß also, um dies zu vermeiden, eine besondere Maßnahme getroffen werden, z.B. wird bei einer als Korrosionsschutz bereits vorverzinnten Leiterplatte der die Kontaktflächen aufweisende Randbereich jeweils mit einer hitzebeständigen Abdeckung versehen. Ist das Kupfermaterial und somit auch die Kontaktflächen der Leiterplatte durch eine Lackschicht als Konservierungsmittel geschützt, so ergibt sich ebenfalls eine über diese Fläche unregelmäßig verteilte Schicht, mit einer Dickenabmessung, die eine einwandfreie Funktion der Gegenkontakte in Frage stellt.

Der Lötvorgang für diese Kontaktflächen ist aber zwingend notwendig, da sonst auf Grund des Konservierungsmittels die Kontaktfähigkeit fehlt.

Es ist die Aufgabe der Erfindung, die für den Lötvorgang vorzunehmenden Maßnahmen zu vereinfachen, und eine optimale Kontaktfähigkeit der Kontaktflächen (Edge-Connectoren) sicherzustellen.

Diese Aufgabe wird durch die im Kennzeichen des Patentanspruches angegebenen Merkmale gelöst. Das Wesentliche der Erfindung besteht darin, daß jede dieser Kontaktflächen (Edge-Connectoren) nicht mehr vollflächig ausgebildet ist, sondern in mehrere miteinander verbundenen Teilflächen strukturiert ist. Diese einzelnen Teilflächen sind hinsichtlich ihrer Abmessungen so bestimmt, daß eine hinsichtlich der sich daran ausbildenden Lotschicht mögliche maximale Dicke bei ihrem Aufbringen nicht überschritten wird. Diese Teilflächen können grundsätzlich in den unterschiedlichsten Formen realisiert sein. Sie können schräg in einem bestimmten Winkel verlaufen oder als eine Gitterstruktur mit quer und längs verlaufenden Flächenanteilen ausgebildet sein. Die miteinander verbundenen Teilflächen können in paralleler Anordnung abschnittsweise in einer sich ändernden Richtung verlaufen (Zickzack-Linienführung).

Für bestimmte Lötverfahren kann es von Vorteil sein, daß die Teilflächen durch eine kammartige Strukturierung gebildet sind. Die einzelnen Zinken sind dabei in Steckrichtung ausgerichtet. Diese Zinken sollen eine Breite von wenigen Zehntelmillimetern nicht überschreiten. Eine derartig strukturierte Kontaktfläche für diese sogenannten Edge-Connectoren erlaubt nun diese ohne irgendwelche Zusatzmaßnahmen unmittelbar in den vorzunehmenden Lötvorgang für die bestückte Leiterplatte einzubeziehen. Durch diese Strukturierung werden diese Kontaktflächen problemlos lötbar, so daß beispielsweise die Verzinnung während des üblichen Wellenlötprozesses erfolgen kann. Dies trifft sowohl auf Leiterplatten mit vorab heiß verzinnter Oberfläche, als auch für solche mit einem aufgebrachten lackartigen Konservierungsmittel zu. Ohne daß der Prozeß zusätzlich gelenkt werden muß, entstehen auf den Teilflächen gleichmäßig dünne und ebene Schichten. Ihre automatisch entstehende Schichtdicken garantieren eine einwandfreie Funktion der federnden Gegenkontakte. Bei Anwendung dieser strukturierten Lötflächen sind die Leiterplatten, deren Oberfläche mit dem lackartigen Konservierungsmittel geschützt ist, problemlos einzusetzen. Da derartige Leiterplatten preisgünstiger als Leiterplatten mit heiß verzinnter Oberfläche sind, ergibt sich dadurch auch eine entsprechende Kostenersparnis, die bei der Vielzahl der eingesetzten Leiterplatten ganz erheblich sein kann. Auf der Kontaktseite werden die mit dem Einsatz moderner Bauelemente notwendigeren kritischeren elektrischen Anforderungen voll erfüllt. Dies gilt unabhängig von der Art des vorab aufgebrachten Schutzüberzuges. Durch die Struktur der Kontaktfläche, insbesondere durch die kammartige Strukturierung, ergibt sich beim Lötvorgang eine Veränderung der Oberflächenspannung der aufgetragenen Schicht, so daß sich durch den entstehenden regelmäßigen Lotabriß kontrolliert eine gleichmäßige Lotschicht automatisch aufbaut.

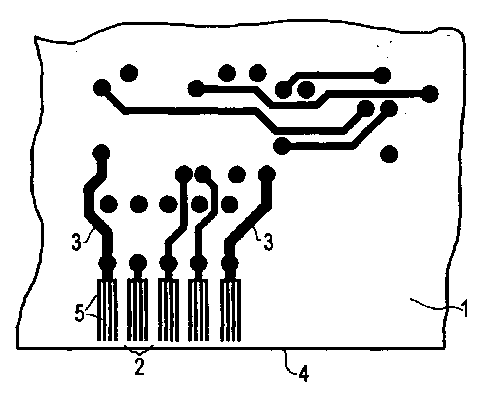

Im Folgenden wird die Erfindung anhand eines in der Zeichnung dargestellten Ausführungsbeispiels näher erläutert. Es zeigt die Teilansicht einer Leiterplatte 1, deren Leiterbahnen 3 an dem an ihrem Randbereich 4 vorhandenen Kontaktflächen 2 enden. Derartige Kontaktflächen können auch auf mehreren Randbereichen vorgesehen sein. Beim bestimmungsgemäßen Gebrauch dieser Leiterplatte wird sie mit diesen Kontaktflächen 2 in eine Gegenkontaktanordnung eingesteckt. Diese Gegenkontaktanordnung stellt beispielsweise eine Federleiste dar. Zur Verbindung von derartigen Leiterplatten untereinander können auch die entsprechenden Steckverbindungen über diese Kontaktflächen untereinander vorgenommen werden. Diese Steckverbindung zwischen dieser Kontaktfläche und den Gegenkontakten dient neben der elektrischen Verbindung auch gleichzeitig zur mechanischen Verbindung. Auf diese Weise kann auch die beispielsweise für eine Nachrüstung erforderliche Verbindung einer Ergänzungsleiterplatte mit einer Grundleiterplatte erfolgen.

Die im unmittelbaren Bereich des Leiterplattenrandes angeordneten Kontaktflächen 2 sind nicht vollflächig ausgebildet. Eine derartige Ausbildung ist dann äußerst problematisch, wenn diese Kontaktflächen beim Prozeß des für die bestückte Leiterplatte vorgenommenen Lötens mit einbezogen werden. Ohne besondere Maßnahmen bilden sich an einer derartigen vollflächigen Kontaktfläche für die eine bestimmte Mindestbreite notwendig ist, unregelmäßige Zinnanhäufungen. Durch diesen unregelmäßigen und zu dicken Lotauftrag sind diese Flächen durch den Gegenkontakt nicht mehr einwandfrei kontaktierbar.

Es werden erfindungsgemäß in Verbindung mit dem Herstellungsprozeß der Leiterplatte diese Kontaktflächen zusätzlich strukturiert. Im Ausführungsbeispiel sind durch eine kammartige Strukturierung einzelne Teilflächen gebildet, die jeweils in die Leiterbahn 3 übergehen. Die einzelnen in Steckrichtung ausgerichteten zinkenförmigen Teilflächen weisen z.B. eine zwischen 0,2 und 0,3 mm liegende Breite auf. Die Breite der zwischen ihnen vorhandenen Aussparung liegt z.B. etwa in der gleichen Größenordnung. Werden nun diese derartig strukturierten Kontaktflächen 2 in den Lötprozeß mit einbezogen, so bildet sich an den Teilflächen eine dünne gleichmäßig verteilte Lotschicht. Es ergibt sich dabei auf den zinkenartigen Teilflächen eine Schichtdickenabmessung, die hinsichtlich der Federwege der verwendeten Gegenkontakte keinerlei Probleme aufwirft. Bei einer durchschnittlichen Dickenabmessung von ungefähr 0,02 mm ist ausgeschlossen, daß für das Federmaterial der Bereich der plastischen Zone erreicht wird. In dem vorgegebenen Auslenkungsbereich kommen die notwendigen Federkräfte zur Wirkung. Wie die Praxis zeigt, wird bei einer derartig strukturierten Kontaktfläche eine sichere Kontaktierung zwischen diesen Teilflächen und dem jeweiligen Gegenkontakt erzielt. Dieser saubere und gleichmäßige Auftrag, der in jedem Fall ohne zusätzliche Steuerung unterhalb der für eine einwandfreie Funktion schädlichen Dickenabmessung bleibt, wird sowohl bei einer durch einen Lacküberzug geschützten Leiterplatte, als auch bei einer vorab heiß verzinnten Leiterplatte erreicht. Bei der erstgenannten Leiterplatte ist im Bereich dieser Kontaktflächen ein kontaktfähiger Schutzüberzug in jedem Falle erforderlich. Ohne einen derartigen Überzug wäre diese Kontaktfläche insbesondere bei mehrfach vorgenommenen Steckversuchen aufs Äußerste korrosionsgefährdet. Es sind also erst durch diese Maßnahme der Strukturierung solche Leiterplatten wirtschaftlich einzusetzen. Durch Vermeidung der vorab vorzunehmenden aufwendigen Heißverzinnung ergeben sich Kosteneinsparungen. Außerdem ist bei Aufbringen eines Lacküberzuges die Gefahr von Plattenverwölbungen ausgeschlossen. Derartige Verwölbungen können bei den durch Heißverzinnung gegen Korrosion geschützten Leiterplatten auftreten.

Unabhängig von der für die Leiterplattenoberfläche verwendeten Schutzschicht (verzinnt bzw. lackartiger Schutzüberzug), ergibt sich bei dem nach der Bestückung der Leiterplatte notwendigen Lötvorgang (sogenannte Wellen-Lötung bzw. Reflow-Lötung) für diese einzelnen, durch die Strukturierung gebildeten Teilflächen auf Grund der geänderten Oberflächenspannungsverhältnisse eine ebene, im höchsten Maße kontaktfähige Schicht. Im Gegensatz zu einer vollflächigen Kontaktfläche können zusätzliche Maßnahmen, die entweder vor oder nach dem Lötvorgang zu treffen sind, entfallen. Durch die erfindungsgemäße Strukturierung der Kontaktflächen 2 werden diese z.B. in dem sowieso vorgesehenen Wellenlötprozeß auch unmittelbar wellenlötbar, wobei sich eine einwandfreie Kontaktierfläche für die Gegenkontakte ergibt.

## Patentansprüche

1. Leiterplatte, die an mindestens einem ihrer Randbereiche wenigstens eine mit einer Leiterbahn verbundene Kontaktflächen aufweist, die dazu dient, bei ihrem bestimmungsgemäßen Gebrauch mit einem Gegenkontaktelement einer Steckeranordnung zu kontaktieren und die mit einer kontaktfähigen Schutzschicht versehen ist,
**dadurch gekennzeichnet,**
daß zur Sicherstellung einer einwandfreien Kontaktfunktion mit dem jeweiligen Gegenkontaktelement die Kontaktfläche (2) jeweils in mehrere miteinander verbundene Teilflächen (5) strukturiert ist und daß diese Teilflächen hinsichtlich ihrer Länge- und/oder Breite derart bemessen sind, daß die in einem ungesteuerten Prozeß aufgebrachte kontaktfähige Schicht eine maximal mögliche Dickenabmessung nicht überschreitet.

2. Leiterplatte nach Anspruch 1,
**dadurch gekennzeichnet,**
daß die Teilflächen durch eine kammartige Strukturierung gebildet sind, deren einzelne Zinken in Steckrichtung verlaufen.

3. Leiterplatte nach Anspruch 2,
**dadurch gekennzeichnet,**
daß die Zinken der Teilfläche und die zwischen ihnen vorhandenen Zwischenräume vorzugsweise angenähert eine gleiche Breite zwischen 0,2 und 0,3 mm aufweisen.

4. Leiterplatte nach Anspruch 1 oder 2,
**dadurch gekennzeichnet,**
daß die kontaktfähige Schicht auf die strukturierte Kontaktfläche unmittelbar durch denselben Lötvorgang aufgebracht ist, der die elektrische Verbindung der auf ihr aufgebrachten Bauelemente mit den Leiterbahnen bewirkt hat.

5. Leiterplatte nach Anspruch 1 oder 4,
**dadurch gekennzeichnet,**
daß in den Fällen, in denen zumindest auf die strukturierte Kontaktfläche als Korrosionsschutz eine lackartige - im Zuge des nach dem Aufbringen der Bauelemente erfolgten Lötvorganges an den mit dem Lötmaterial in Kontakt tretenden Stellen aufbrechende - Schicht aufgebracht ist, nach dem Lötvorgang durch die Wirkung der Strukturierung der Kontaktfläche diese automatisch jeweils eine gleichmäßig dünne und die sichere Kontaktierungsmöglichkeit für en jeweiligen Gegenkontakt bietende Lotschicht aufweist.

6. Leiterplatte nach Anspruch 1 oder 4,
**dadurch gekennzeichnet,**
daß in den Fällen in denen zumindest auf die strukturierte Kontaktfläche als Korrosionsschutz eine leitende Schicht vorab aufgebracht ist, aufgrund des nach dem Aufbringen der Bauelemente erfolgten Lötvorganges durch die Wirkung der Strukturierung der Kontaktfläche, die auf ihr vorhandene ursprüngliche Schicht automatisch auf eine die sichere Kontaktierungsmöglichkeit für den jeweiligen Gegenkontakt bietende Dickenabmessung homogenisiert ist.

7. Leiterplatte nach einem der vorhergehenden Ansprüche,
**dadurch gekennzeichnet,**
daß die Gegenkontaktelemente die Federn einer Kontaktfederleiste darstellen.
